# EUROPEAN PATENT APPLICATION

(11) **EP 3 091 821 A1**
(43) Date of publication of application: **09.11.2016**
(21) Application number: 15166936.3
(22) Date of filing: 08.05.2015
(51) Int. Cl.: H05K 1/16, H05K 3/46, G06F 3/044, H01L 41/04, H05K 1/02

(54) **PRINTED CIRCUIT BOARD**

(71) Applicant: AT & S Austria Technologie & Systemtechnik Aktiengesellschaft, 8700 Leoben-Hinterberg (AT)
(72) Inventor: Leitgeb, Markus, 8793 Trofaiach (AT); Stahr, Johannes, 8605 St. Lorenzen (AT)
(74) Representative: Patentanwaltskanzlei Matschnig & Forsthuber OG

(57) **Abstract**

In a connection system (1) for electronic components comprising a plurality of insulating layers (2, 5, 5') and conductive layers (2', 2"), and comprising at least one cavity (3), the at least one cavity (3) is covered on both sides thereof at least by an electrode-group (4, 4') of an insulating layer (5', 5") followed by a conductive layer (6', 6"), the electrode-groups (4, 4') forming electrodes of a capacitor. A method for detecting failure of a connection system (1) for electronic components comprises the steps of continuously measuring the capacitance of the at least one capacitor formed by the electrode groups (4, 4') and generating a failure message when detecting a discontinuity in the progression of capacitance of the at least one capacitor.

## Description

### BACKGROUND OF THE INVENTION

### Field of the Invention

The invention relates to a connection system for electronic components comprising a plurality of insulating layers and conductive layers, and comprising at least one cavity, the use of the inventive connection system for electronic components as well as a method for detecting failure of the inventive connection system for electronic components.

### Description of the Related Art

The invention relates to connection systems for electronic components in general, wherein electronic components such as transistors, integrated circuits (ICs, microchips) and the like are arranged on or embedded within a panel carrying and electrically connecting those electronic components. Such connection systems can be printed circuit boards (PCBs) or IC-substrates used for connecting a single integrated circuit or a plurality of integrated circuits to a printed circuit board. In fact, IC-substrates and printed circuit boards are highly similar in their basic functionalities and differ merely in size as will be explained and defined at a later stage of this description. For the purposes of this description the terms "printed circuit board", "IC-sub-strate" and "connection system for electronic components" can be used interchangeably. For the sake of simplicity the following description is mostly directed to printed circuit boards only.

Printed circuit boards and IC-substrates, also referred to as printed wiring boards or connection system for electronic components, are panels carrying and electrically connecting electronic components such as transistors and the like and, hence, form vital parts of electronic devices. Printed Circuit boards have a more or less complex structure depending on the specific application. In general, a printed circuit board comprises a plurality of alternately applied conductive and insulating layers and the conductive layers are bonded together by hardening panels or plies of glass fibres impregnated with organic resin, said panels forming the insulating layers. Such panels for use in the production of printed circuit boards are widely known in the industry as "prepregs" (preimpregnated fibres), which are delivered and processed in an uncured, hence viscous state of the organic resin. The actual insulating layer results when the organic resin has cured. The insulating layers carry conductive layers, for example formed of copper foil, the conductive layers being appropriately processed to form wirings to electrically connect the electronic components. While insulating layers are mostly continuous to provide electric insulation between the conductive layers of the printed circuit board , the conductive layers are usually strongly patterned and open work. Modern printed circuit boards allow for a high degree of integration of electronic components and their appropriate wiring. In the technical field of printed wiring boards, IC-substrates are known to offer similar functionality in terms of alternately applied conductive and insulating layers, however, IC-substrates are much smaller and often serve to connect a microchip to a printed circuit board. To this end, the insulating layers of IC-substrates are often produced of glass or ceramic materials which allows for smaller, high-precision structures.

There is, however, a constant need for further miniaturisation in the electronic industry in order to provide consumers and professionals with ever smaller yet more capable electronic devices and installations which require more electronic components to be packaged and wired in a smaller space. There is a number of applications that use cavities arranged in a printed circuit board, offering the possibility to arrange electronic components therein. Especially components such as buttons, trackpads, microphones and loudspeakers consume considerable space on a printed circuit board and there is, thus, the need to provide such functionalities on a printed circuit board without mounting such components on the surface of a printed circuit board.

### SUMMARY

In order to further increase the degree of integration of such components into a printed circuit board the invention is thus directed to a connection system for electronic components forming components such as microphones and loudspeakers, trackpads and the like within the thickness of the connection system for electronic components. In addition to the favorably small dimensions required on the connection system for electronic components to provide these functionalities, the invention provides improved protection to the components thus formed.

### DETAILED DESCRIPTION

In particular the invention provides for a connection system for electronic components of the initially mentioned kind which is characterized in that the at least one cavity is covered on both sides thereof at least by an electrode-group of an insulating layer followed by a conductive layer, the electrode-groups forming electrodes of a capacitor. In other words, a cavity and neighboring layers in the connection system for electronic components form a capacitor that can serve as a microphone and/or a loudspeaker or trackpad or the like. The cavity in the connection system for electronic components hereby serves as the dielectric and the insulating layers and the conductive layers of the electrode-groups serve as the electrodes providing certain flexibility to enable vibration of the electrode group. The cavity provides a sort of resonant cavity which, in the case of the capacitor serving as a microphone, causes at least one of the electrode groups to vibrate according to surrounding acoustic waves. The vibrating movement of the at least one electrode group brings about a change in distance between the electrode-groups, also referred to as membrane groups, thus changing the capacitance of the capacitor. The changes in capacitance can be interpreted by a processing unit like a microcomputer on or embedded within the printed circuit board as the result of the initial sound waves so that overall, information on the acoustic environment is gathered that can be reinterpreted to reproduce this sound. Conversely, when the invention is to be used as a loudspeaker, the electrodes of the capacitor are supplied with current, which leads to changes in the distance between the electrode-groups. Provided the current is appropriately controlled, at least one of the electrode-groups will vibrate thus emitting sound.

Since the microphone or the loudspeaker is arranged within the thickness of the printed circuit board and since it is not necessary to provide any openings for the sound to enter the cavity the invention provides for a microphone or a loudspeaker that is sealed against dust and water and is thus not prone to early malfunction.

According to a preferred embodiment of the present invention, the cavity has a thickness of between 50 µm and 1000 µm, in particular between 150 µm and 850 µm, in particular between 300 µm and 700 µm, in particular between 450 µm and 550 µm, in particular 500 µm. (µm = micrometer). When these preferred thicknesses apply the person skilled in the art considers the inventive connection system for electronic components as printed circuit board.

According to another preferred embodiment of the present invention, the cavity has a thickness of between 5 µm and 50 µm, in particular between 15 µm and 35 µm, in particular 25 µm.

When these preferred thicknesses apply the person skilled in the art considers the inventive connection system for electronic components as IC-substrate.

As mentioned before the present invention can also be carried out by using glass or ceramics as the insulating layers, it is however preferred that at least one insulating layer of the connection system for electronic components is made from resin material, preferably chosen from the group comprised of epoxy resin, polyimide and build-up films. A typical example of a build-up film is the insulating film "ABF" by Ajinomoto Fine-Techno Co., Inc. of Japan. Also preferred are materials that have properties similar to epoxy in their insulating and mechanical properties and in the way they are processed in the art of producing printed wiring boards.

Also, at least one insulating layer of the connection system for electronic components can be made from reinforced resin material, preferably reinforced by glass structures and more preferably FR4-material as it is in conformity with a preferred embodiment of the present invention. In particular FR4-prepreg is known as such a material and is widely used in the production of printed wiring boards.

In order to increase the changes in capacitance and promote vibration of the electrode-groups or membrane-groups, it can be preferred that at least one insulating layer of the electrode-groups is made from a material chosen from the group comprised of epoxy resin, polyimide, liquid crystal polymer, polyethylene terephthalate, polyethylene naphthalene, build-up films and FaradFlex®. FaradFlex® is a registered trade mark of Oak-Mitsui Technologies and is often used for the production of capacitors. It is electrically insulating and provides favorable properties for laminating it to the FR4-material of a printed circuit board. Other materials in this group are known to the person skilled in the art as flexible insulating materials of copper-clad laminates which, in the context of the present invention can be appropriately structured to form the electrode groups.

Moreover it can be provided that the at least one cavity is at least partly filled with a material adapted to increase the capacitance of the cavity, as it is in accordance with a preferred embodiment of the present invention. In this context it is particularly preferred that the material adapted to increase the capacitance of the cavity is a paste-like material containing BaTiO3. Such a material can easily be applied in a cavity in a printed circuit board according to the present invention before applying an electrode-group. BaTiO3 will provide considerably increased capacitance of the capacitor formed in the printed circuit board of the present invention and will thus enable clear signals from the microphone/loudspeaker thus formed.

Within the context of the present invention it is also conceivable to use additional means for exciting the electrode-group of the inventive capacitor to vibrate in order to serve as a loudspeaker. In this context it is particularly preferred when a piezoelectric material is applied on an electrode-group on the inside of the cavity. The piezoelectric material can be excited by an electric field so that the piezoelectric material causes the electrode-group to vibrate and thus emit sound.

In addition to the already described functionalities of microphone and/or loudspeaker the present invention allows for cheap, yet effective production of track pads and other pointing devices and buttons of personal computers, smartphones and the like when the printed circuit board comprises a plurality of cavities to form a plurality of capacitors on the connection system for electronic components as it is in accordance with the preferred embodiment of the present invention. Forming cavities in a printed circuit board is easy to be achieved by techniques well known in the art of the production of printed circuit boards and the present invention thus provides a simple way to arrange a large number of capacitors next to each other in a printed circuit board. When a user touches the printed circuit board or a foil covering the printed circuit board according to the present invention, the capacitor or the capacitors in the proximity of the user's skin change their capacitance and thus yield signals that allow tracking of the user's finger on the track pad or pointing device. This information can be translated into movement of a cursor on a screen as it is well known in computer technology.

According to a preferred of the present embodiment of the present invention at least one electrode group is glued to the connection system for electronic components. Gluing the electrode-group to the printed circuit board comprising the at least one cavity can be particularly effective when the insulating layers of the electrode groups are made from FaradFlex®.

According to another preferred embodiment of the present invention the at least one electrode-group is fixed to the connection system for electronic components by means of a layer of no-flow-prepreg. Securing insulating layers to a semi-finished printed circuit board by means of a no-flow-prepreg is a technique well known in the art of producing printed circuit boards and can thus easily be carried out to realize the present invention.

Preferably, the connection system comprises a processing unit for processing information gathered from the the electrode-groups forming electrodes of a capacitor. By this preferred embodiment of the present invention a functional module can be provided that comprises all the components necessary to profit from the inventive connection system for electronic components.

As already stated, the inventive connection system for electronic components can be used as button, trackpad, pointing device, microphone, loudspeaker and/or pressure sensor as it is in conformity with a preferred embodiment of the present invention

The inventive method for detecting failure of the inventive connection system for electronic components is characterized by the following steps:
continuously measuring the capacitance of the at least one capacitor formed by the electrode groups (4,4')
and generating a failure message when detecting a discontinuity in the progression of capacitance of the at least one capacitor.

Failure of the inventive connection system for electronic components will mostly occur as breaking of the electrode groups, be it the insulating layers or the electrodes formed thereon. In both cases the capacitance of the capacitor will discontinuously change as compared to the normal progression of the capacitance of the capacitor over time. Thus, a discontinuous change in the capacitance can be interpreted as failure if the inventive connection system for electronic components.

According to preferred embodiment of this inventive method, the failure message is interpreted as the occurrence of a predefined pressure surrounding the connection system for electronic components. The inventive connection system for electronic components can be designed to break its electrode groups more or less precisely at a predefined pressure so that breaking can be attributed to this predefined pressure.

The present invention in the following is described by way of an exemplary embodiment and with reference to the accompanying drawings in which
Fig 1 shows a sectional side view of an exemplary connection system for electronic components according to the present invention;
Fig 2a and 2b show the action of the electrode-groups or membrane-groups;
Fig 3a and 3b show top and bottom views to illustrate the shape of the electrodes of a capacitor of the inventive printed circuit board;
Fig 4 shows a preferred embodiment in which a piezoelectric material is applied on an electrode-group or membrane-group on the inside of the cavity;
Fig 5 shows a preferred embodiment in which an inventive printed circuit board comprises a plurality of cavities;
Fig 6a to 6g illustrate a method that can be used to produce a cavity within an inventive printed circuit board;
Fig 7a to 7d show another method that can be used to produce a cavity within an inventive printed circuit board and
Fig 8a to 8e show a method that can be used to produce an inventive printed circuit board comprising a plurality of cavities to form a plurality of capacitors.

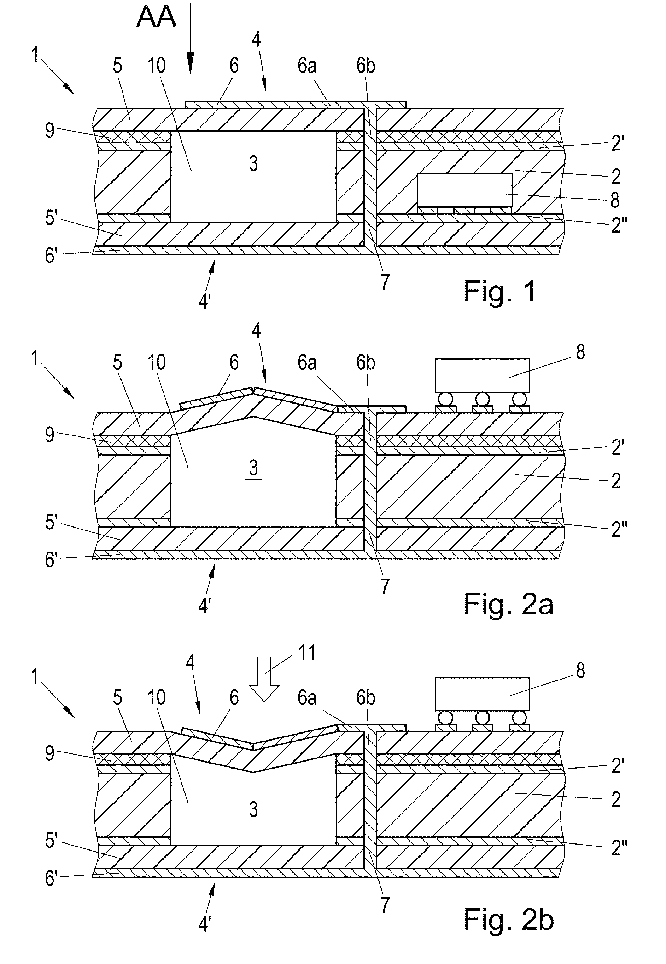

In Fig 1 a part of an inventive connection system for electronic components or printed circuit board is denoted by reference numeral 1. The printed circuit board 1 is comprised of a core material of an insulating layer 2 for example formed of prepreg material in which a cavity 3 is formed. The core material, in this case, is a copper-clad laminate having copper layers 2' and 2" on either side thereof. The cavity 3 is being covered on both sides thereof by electrode-groups 4 and 4'. The electrode-groups 4,4' each are comprised of an insulating layer 5,5' followed by a conductive layer 6, 6'. The person skilled in the art will appreciate that the two electrode-groups 4 and 4' being arranged opposite to each other and being separated by the cavity 3 form electrodes of a capacitor when they are appropriately connected by line 7 to an processing unit 8. In the example according to Fig. 1 the processing unit 8 is embedded within the printed circuit board 1. and itallows for processing of information gathered from the changes in capacitance of the capacitor. To this end, it is of course necessary that at least one of the electrode groups 4 and 4' provides at least a certain flexibility to be able to become depressed or to be able to vibrate under the influence of mechanical pressure or of pressure waves, such as sound waves. In Fig 1 it can be seen that the electrode-group 4 is attached to the insulating layer 2 by means of an intermediate layer 9. The intermediate layer 9 can be glue or a layer of no-flow-prepreg in order to fix the electrode-group 4 to the printed circuit board. Reference numeral 10 denotes a material that is filled into the cavity which is adapted to increase the capacitance of the cavity. According to a preferred embodiment of the present invention this material is a paste-like material containing bariumtitanate. In the example of Fig 1, the processing unit 8 is embedded in the printed circuit board 1.

The flexibility of the electrode groups 4, 4' or membrane-groups are illustrated by Fig 2a) and 2b) where it can be seen that the electrode group 4 is flexible enough to move up and down according to the influence of pressure or sound waves or according to the influence of mechanical pressure as symbolized by arrow 11. By this movement, the clearance of the cavity 3 becomes larger and smaller according to the frequency of the influence of the pressure waves or according to the number of times the electrode-group 4 is pressed by mechanical forces such as a finger of a user which changes the overall capacitance of the capacitor arrangement herein described. This data can be processed in the processing unit 8 to record sound or to detect the touch of the finger of a user or the touch of a stylus which can of course be used to compute whatever commands in an electronic device.

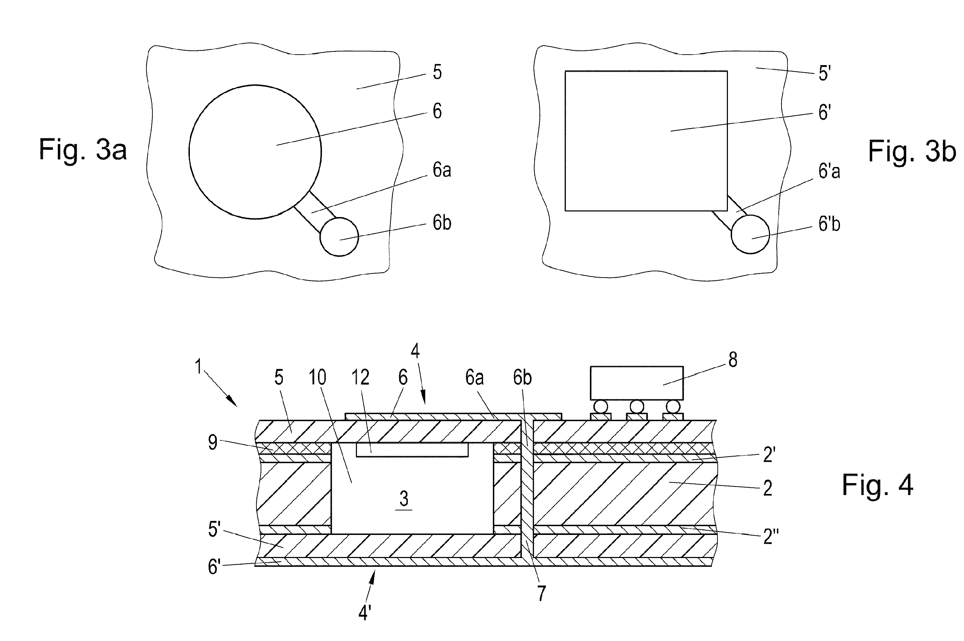

In Fig 3a and 3b the electrodes of the capacitor of the inventive connection system for electronic components are depicted in an exemplary shape. Fig 3a, which is a view on the inventive printed circuit board according to Fig 1 from the direction of arrow AA, shows a rounded electrode 6 having a line 6a and a contact pad 6b which serves for connection to line 7 depicted in Fig 1, 2a and 2b. The round shape and the angular shape of the electrodes in Fig 3a and 3b are only exemplary shapes and can be any other shape useful for electrodes of a capacitor.

Fig 4 shows a preferred embodiment of the present invention, in which a tile 12 of a piezoelectric material is applied on the electrode-group 4 or membrane-group 4. While it is possible to excite the membrane-group 4 depicted in Fig 2a) and 2b) to vibrate in order to emit sound by charging and discharging the capacitor in the invented printed circuit board, the preferred embodiment according to Fig 4 offers an enhanced functionality to this end, since the tile 12 can be excited by an electric field to vibrate by the piezo-effect. This effect can promote vibration already caused by charging and discharging of the capacitor.

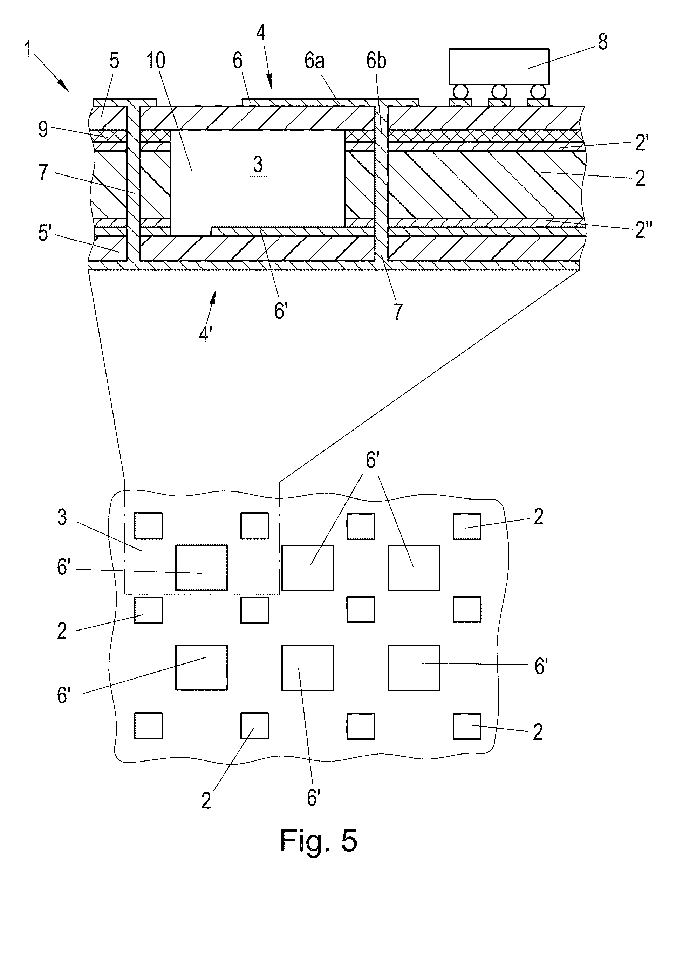

Fig 5 shows an embodiment of the present invention in which a plurality of cavities is formed in a printed circuit board. Fig 5 is a top view on the inventive connection system for electronic components without the upper electrode-group 4 applied so that a bottom electrode 6' can be seen in each cavity 3. The plurality of cavities 3 in this preferred embodiment are covered by an insulating layer with appropriately positioned top electrodes 6 as can be seen in the enlarged sectional side view of Fig 5. Also in Fig 5 it can be seen that the walls of insulating layer 2 in the left hand area of the top view of Fig 5 can be reduced to only pillars as in the right hand area of the top view of Fig 5. The person skilled in the art will appreciate that the plurality of electrodes 6 and 6' form a plurality of capacitors which for example can be used as a track pad or other pointing device for example in a portable computer or smart phone.

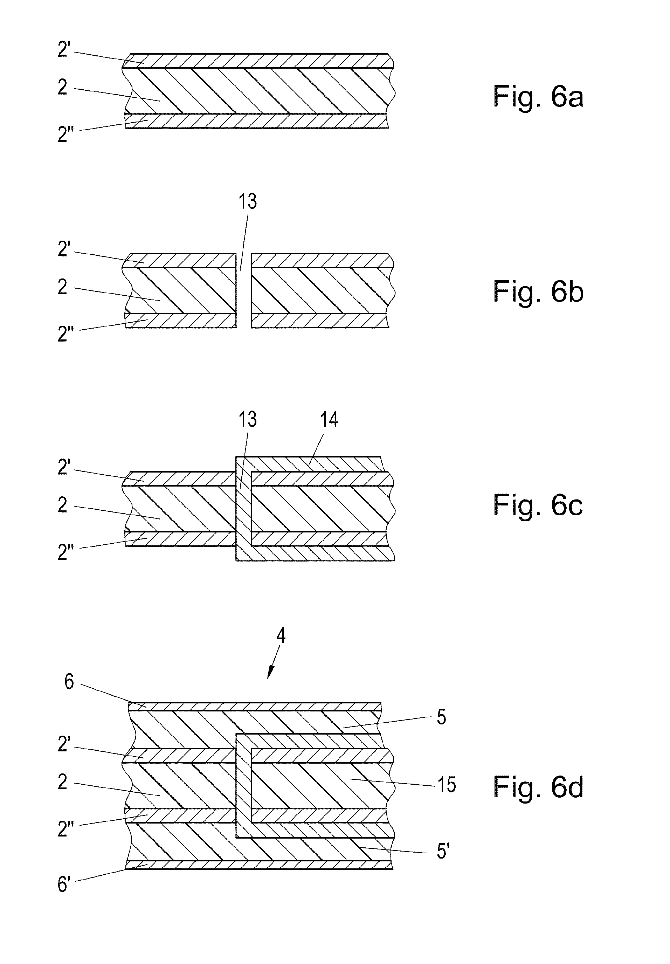

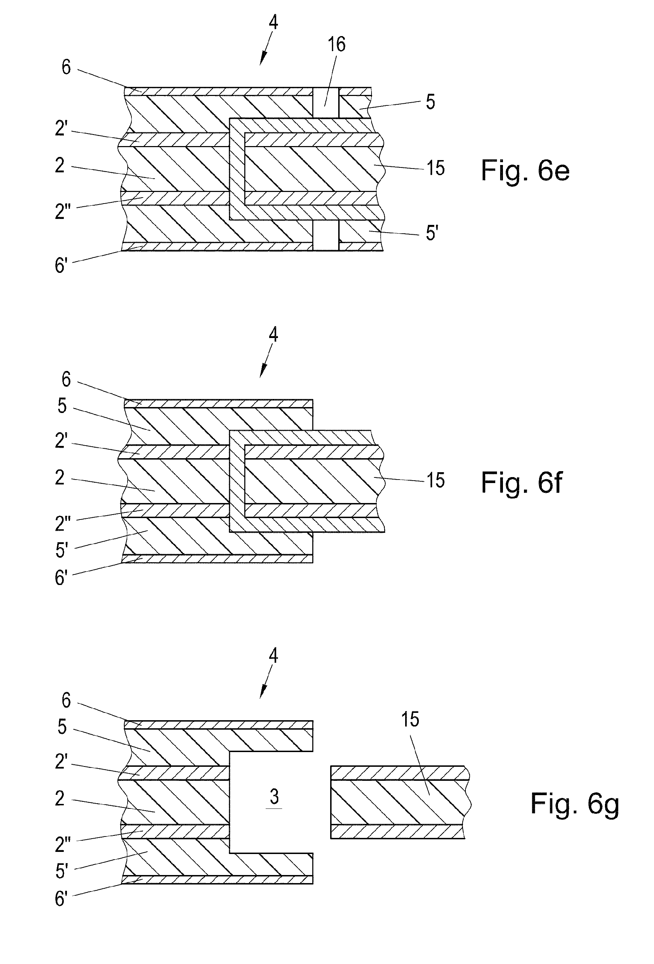

According to Fig 6a) a cavity in a printed circuit board can be produced starting form a core material comprising an insulating layer 2 and layers of copper 2' and 2". The insulating layer 2 preferably has a thickness of between 50 µm and 1000 µm and is preferably made of a prepreg material, in particular FR-4. In the production step of Fig 6b the material is cut for example by a laser and subsequently the portion to be removed and separated by the cut 13 is covered with release layer 14 which is well known in the art. The release layer 14 also flows into the area of the cut 13 and will prevent firm adhesion of additional layers laminated onto the core material as depicted in Fig 6d. Subsequently (Fig 6e), the additionally laminated layers are cut for example by a laser and the end of a board with the plug 15 is removed by machining (Fig 6f) upon which the plug 15 can be pulled out of the printed circuit board leaving a cavity 3 therein.

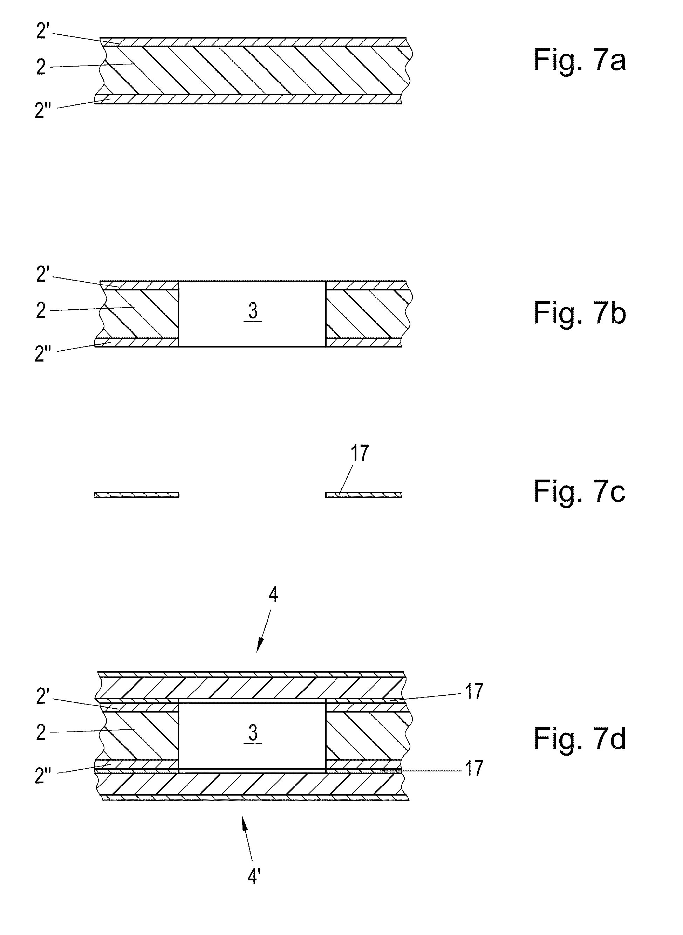

Alternatively, it can also be proceeded that again starting from a core material 2, a hole or cavity 3 is provided therein (Fig 7a and 7b) and a no-flow-prepreg-material is appropriately cut (Fig. 7c)) to fix the electrode-groups 4 and 4' to the core material by lamination of the core 2, the no-flow-prepreg-material 17 and the electrode-groups 4 and 4' (Fig 7d).

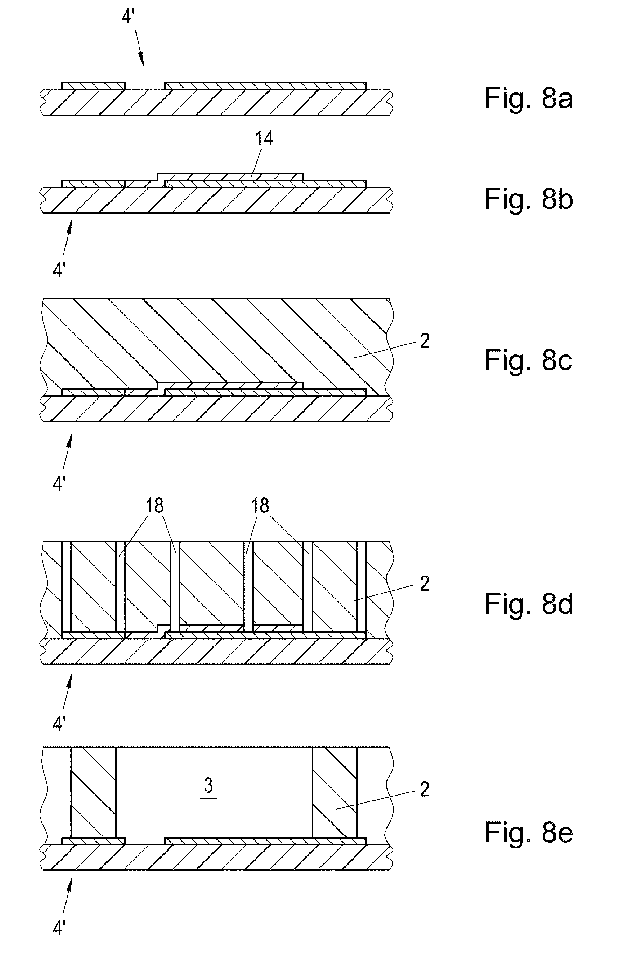

The process for the production of a plurality of cavities in the inventive printed circuit board, for example to produce a track pad or other pointing device, involves structuring a cooper-clad-laminate by known methods to obtain an electrode-group 4' (Fig 8a)) and covering the area of the future cavity with a release layer 14 (Fig 8b)). According to the step depicted in Fig 8 an insulating layer 2 is laminated onto the electrode-group 4' which is then cut in sections by laser-cutting. The cuts are denoted by reference numerals 18 in Fig 8d). Accordingly the insulating layer 2 can easily be removed from the electrode-group 4' to yield the cavity 3. Finally, the cavity 3 can be covered with an electrode-group 4 either by gluing or by laminating with a no-flow-prepreg-material.

## Claims

1. Connection system (1) for electronic components comprising a plurality of insulating layers (2,5,5') and conductive layers (2', 2", 6, 6'), and comprising at least one cavity (3), **characterized in that** the at least one cavity (3) is covered on both sides thereof at least by an electrode-group (4, 4') of an insulating layer (5', 5") followed by a conductive layer (6', 6"), the electrode-groups (4,4') forming electrodes of a capacitor.

2. Connection system for electronic components according to claim 1, **characterized in that** the cavity (3) has a thickness of between 50 µm and 1000 µm, in particular between 150 µm and 850 µm, in particular between 300 µm and 700 µm, in particular between 450 µm and 550 µm, in particular 500 µm.

3. Connection system for electronic components according to claim 1, **characterized in that** the cavity (3) has a thickness of between 5 µm and 50 µm, in particular between 15 µm and 35 µm, in particular 25 µm.

4. Connection system for electronic components according to one of claims 1 to 3, **characterized in that** at least one insulating layer (2, 5, 5') of the connection system (1) for electronic components is made from resin material, preferably chosen from the group comprised of epoxy resin, polyimide and build-up films.

5. Connection system for electronic components according to one of claims 1 to 3, **characterized in that** at least one insulating layer (2, 5, 5') of the connection system (1) for electronic components is made from reinforced resin material, preferably reinforced by glass structures and more preferably FR4-material.

6. Connection system for electronic components according to one of claims 1 to 5, **characterized in that** at least one insulating layer (5,5') of the electrode-groups (4,4') is made from a material chosen from the group comprised of epoxy resin, polyimide, liquid crystal polymer, polyethylene terephthalate, polyethylene naphthalene, build-up films and FaradFlex®.

7. Connection system for electronic components according to one of claims 1 to 6, **characterized in that** the at least one cavity (3) is at least partly filled with a material adapted to increase the capacitance of the cavity.

8. Connection system for electronic components according to claim 7, **characterized in that** the material adapted to increase the capacitance of the cavity (3) is a paste-like material containing BaTiO3.

9. Connection system for electronic components according to one of claims 1 to 8, **characterized in that** a piezoelectric material is applied on an electrode-group (4,4') on the inside of the cavity (3).

10. Connection system for electronic components according to one of claims 1 to 9, **characterized in that** the printed circuit board (1) comprises a plurality of cavities (3) to form a plurality of capacitors on the printed circuit board (1).

11. Connection system for electronic components according to one of claims 1 to 10, **characterized in that** at least one electrode group (4, 4') is glued to the connection system (1) for electronic components.

12. Connection system for electronic components according to one of claims 1 to 11, **characterized in that** the at least one electrode-group (4, 4') is fixed to the printed circuit board (1) by means of a layer of no-flow-prepreg material (17).

13. Connection system for electronic components according to one of claims 1 to 12, **characterized in that** the connection system (1) comprises a processing unit (8) for processing information gathered from the the electrode-groups (4, 4') forming electrodes of a capacitor.

14. Connection system for electronic components according to claim 13, **characterized in that** the processing unit (8) for processing information gathered from the electrode groups (4, 4') forming electrodes of a capacitor is embedded in the connection system (1) for electronic components.

15. Use of a connection system according to one of claims 1 to 14 as button, trackpad, pointing device, microphone, loudspeaker and/or pressure sensor.

16. Method for detecting failure of a connection system (1) for electronic components according to one of claims 1 to 15, **characterized by** the following steps:
continuously measuring the capacitance of the at least one capacitor formed by the electrode groups (4,4')
and generating a failure message when detecting a discontinuity in the progression of capacitance of the at least one capacitor.

17. Method according to claim 16, **characterized in that** the failure message is interpreted as the occurrence of a predefined pressure surrounding the connection system (1) for electronic components.
